# EUROPEAN PATENT APPLICATION

(11) **EP 2 685 459 A1**
(43) Date of publication of application: **15.01.2014**
(21) Application number: 13174871.7
(22) Date of filing: 03.07.2013
(51) Int. Cl.: G11C 16/34, G06F 12/02

(54) **Hardware flash memory wear monitoring**

(30) Priority: 09.07.2012 US 201213544374
(71) Applicant: Hamilton Sundstrand Corporation, Windsor Locks, CT 06096-1010 (US)
(72) Inventor: Rametta, Dean Anthony, Glastonbury, CT Connecticut 06033 (US)
(74) Representative: Hughes, Andrea Michelle

(57) **Abstract**

A system for monitoring wear in a flash memory device 12 that is written by receiving program and erase commands from a microprocessor 16 on a memory bus 20 include non-volatile memory 18 separate from the flash memory device that stores a number of completed erase cycles for each sector of the flash memory device; and a memory monitor circuit 14 that monitors the memory bus cycles for a completed erase cycles for cycles for erased sector and updates the number of completed erase cycles in the non-volatile memory for the erased sector.

## Description

### BACKGROUND

The present invention relates to flash memory, and in particular to a system and method for monitoring wear of flash memory in hardware.

Flash memory is a type of non-volatile memory used for storing information electronically. Flash memory can be implemented as NOR flash memory or NAND flash memory. In NOR flash memory, the default state of a bit is a logic "1." To program the bit to a logic "0," a voltage is applied to the bit's control gate that is large enough to cause electrons to jump onto a floating gate of the bit. To erase the bit, in effect returning it to its default state of a logic "1," a voltage of opposite polarity is applied to the control gate, causing the electrons to jump off of the floating gate.

Flash memory can only handle so many erase cycles before the memory becomes unreliable. Although any bit may be individually programmed at any time, bits may only be erased on a sector-wide basis. Because of this, wear leveling has been implemented to control the number of erase cycles for each sector of flash memory. Wear leveling has been implemented in software, and erase counts for each sector are generally stored in the same flash memory device that is being monitored.

In critical systems, such as those onboard an aircraft, it is important to ensure that wear leveling is being performed properly so as to maximize the life of the flash memory device. In the past, wear monitoring has been implemented in the same software that is in charge of wear leveling. There is a need to provide a more reliable system for ensuring proper functionality of wear leveling techniques.

### SUMMARY

A system for monitoring wear in a flash memory device that is written by receiving program and erase commands from a microprocessor on a memory bus includes a non-volatile memory and a memory monitor circuit. The non-volatile memory is separate from the flash memory device and stores a number of completed erase cycles for each sector of the flash memory device. The memory monitor circuit monitors the memory bus for a completed erase cycle for an erased sector and updates the number of completed erase cycles in the non-volatile memory for the erased sector.

### BRIEF DESCRIPTION OF THE DRAWINGS

FIG. 1 is a block diagram illustrating a flash memory wear monitor system according to an embodiment of the present invention.

FIG. 2 is a flowchart illustrating a method of monitoring wear of a flash memory device according to an embodiment of the present invention.

### DETAILED DESCRIPTION

A flash memory monitor system is disclosed that is implemented in hardware. The system includes a microprocessor, a flash wear monitor circuit, and a non-volatile memory. The microprocessor issues program and erase commands to the flash memory device over a bus. The flash wear monitor circuit monitors the bus for an erase command sequence issued from the microprocessor to the flash memory device. When an erase command sequence is detected, the wear monitor circuit determines the sector that is being erased, verifies that the erase occurred, and updates an erase count for the erased sector in the non-volatile memory. In this way, hardware wear monitoring can be used to ensure that wear leveling techniques are functioning properly.

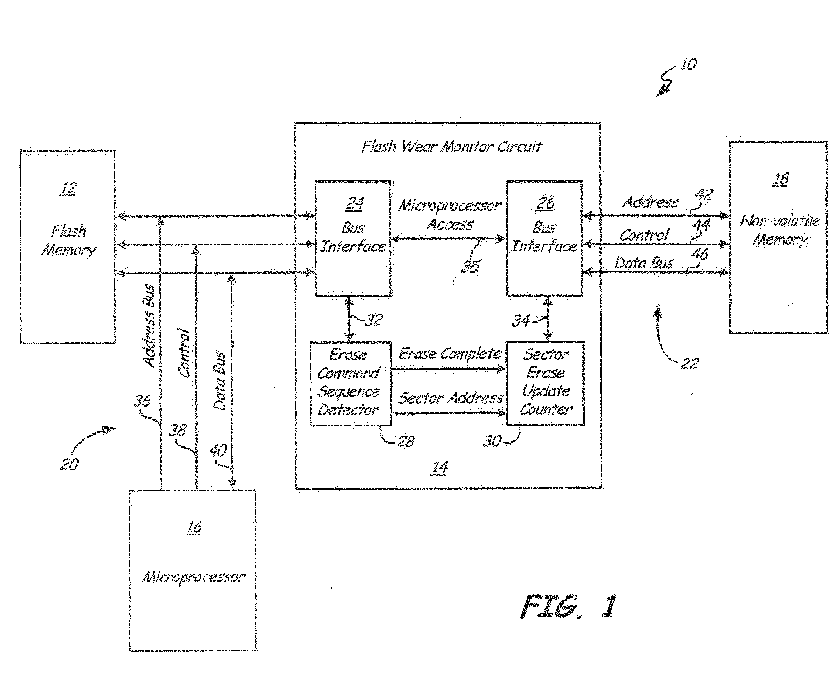

FIG. 1 is a block diagram illustrating a system 10 for monitoring wear leveling of flash memory device 12. System 10 includes flash wear monitor circuit 14, microprocessor 16, non-volatile memory 18, local bus 20, and non-volatile memory bus 22. Flash wear monitor circuit 14 includes bus interfaces 24 and 26, erase command sequence detector 28, sector erase update counter 30, internal buses 32 and 34, and microprocessor access bus 35. Local bus 20 includes address bus 36, control bus 38, and data bus 40. Non-volatile memory bus 22 includes address bus 42, control bus 44, and data bus 46. Flash memory device 12 is a flash memory storage device, or a plurality of devices, such as NOR flash memory. Non-volatile memory 18 is any non-volatile memory storage device, such as a separate non-volatile static random-access memory (SRAM) device.

Microprocessor 16 issues program and erase command sequences to flash memory device 12. Microprocessor 16 is connected to flash memory device 12 through local bus 20. Local bus 20 is any data communication bus capable of transmitting digital signals. When microprocessor 16 wishes to overwrite data to flash memory 12, the entire sector that is being written must first be erased. When issuing an erase command sequence, microprocessor 16 provides a series of signals on bus 20 to indicate that a sector needs to be erased. Microprocessor 16 also provides the address of the sector to be erased on address bus 36.

Flash wear monitor circuit 14 tracks the erase cycles for each sector of flash memory 12. Flash wear monitor circuit 14 may be implemented as any type of microcontroller, such as a field-programmable gate array (FPGA). Local bus interface 24 receives the data on local bus 20 and provides that data to erase command sequence detector 28 over internal bus 32. Erase command sequence detector 28 is implemented, for example, using digital logic. Erase command sequence detector 28 monitors control bus 38 over internal bus 32 for a sequence of commands indicating an erase command. When an erase cycle is completed by flash memory device 12, flash memory device 12 provides an acknowledgement to microprocessor 16 on control bus 38 and data bus 40. Once an erase command sequence is detected by sequence detector 28, control bus 38 and data bus 40 are monitored for this acknowledgement signal. Once this acknowledgment signal is detected, erase command sequence detector 28 indicates that an erase cycle has occurred (via an "erase complete" signal) and provides an address of the sector that has been erased (via a "sector address" signal) to sector erase update counter 30. No action is taken by flash wear monitor circuit 14 for read commands issued from microprocessor 16 because reading data from flash memory device 12 is not detrimental to the device.

Sector erase update counter 30 tracks the number of completed erase cycles for each sector of flash memory device 12. Sector erase update counter 30 is implemented, for example, using digital logic. Sector erase update counter 30 interfaces with bus interface 26 through internal bus 34. Sector erase update counter 30 issues read and write command sequences on control bus 44 to update non-volatile memory 18. When sector erase update counter 30 receives an indication of a completed erase cycle from erase command sequence detector 28, sector erase update counter 30 updates an erase cycle count in non-volatile memory 18 that corresponds to the address provided by erase command sequence detector 28. To accomplish this, sector erase update counter 30 first obtains the current count for the erased sector by issuing a read command on control line 44 for the address of non-volatile memory that contains the erase count for the erased sector. The address is provided on address line 42 and the current count is returned from non-volatile memory 18 on data line 46. The count is then updated by sector erase update counter 30 and a write command is issued on control line 44 with the address on address line 42 and the updated count on data line 46 to store the updated count in non-volatile memory 18.

Erase counts may be accessed from non-volatile memory by microprocessor 16 through flash wear monitor circuit 14. Microprocessor 16 sends read and write bus cycles on local bus 20 that are intended for non-volatile memory 18. These command sequences are received at local bus interface 24 and are passed along to local bus interface 26 over microprocessor access bus 35. The requests go to non-volatile memory 18 over non-volatile memory bus 22 and data is returned along the same path. In this way, software can be executed on microprocessor 16 to retrieve and analyze the erase cycle counts that have been accumulated in non-volatile memory 18, which is separate hardware from flash memory device 12. Therefore, it can be verified that all erase cycle counts are similar and wear leveling is therefore being performed properly for flash memory device 12.

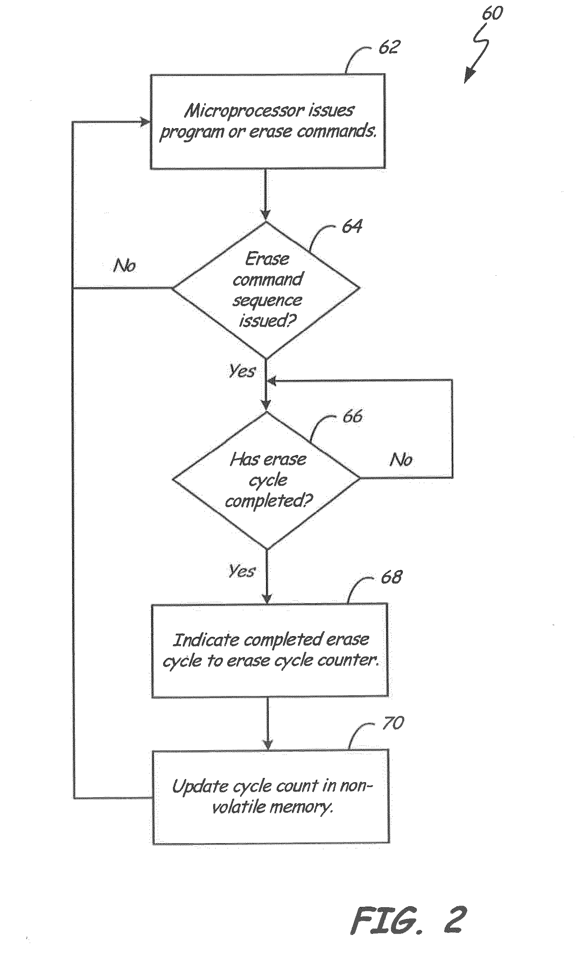

FIG. 2 is a flowchart illustrating method 60 for monitoring wear of flash memory device 12 according to an embodiment of the present invention. At step 62, microprocessor 16 issues a program or erase command sequence on local bus 20. Erase command sequence detector 28 monitors local bus 20. At step 64, erase command sequence detector 28 determines if the issued command sequence is an erase command sequence. If it is, method 60 proceeds to step 66. If it is not, method 60 returns to step 62. At step 66, it is determined if an erase cycle has completed. Erase sequence detector 28 monitors local bus 20 for an acknowledgement from flash memory device 16. If the erase cycle has been completed, method 60 proceeds to step 68. If the erase cycle has not been completed, method 60 remains at step 66. A time-out may be implemented to break an infinite loop if sequence detector 28 does not detect the acknowledgement from flash memory device 12. At step 68, erase command sequence detector 28 indicates an erase cycle has been completed and provides a sector address associated with the erase cycle to sector erase update counter 30. At step 70, sector erase update counter 30 updates an erase cycle count for the provided sector address in non-volatile memory 18. Method 60 then returns to step 62, and method 60 continues to loop during the entirety of normal system operation.

In this way, the present invention describes a system and method for monitoring wear in a flash memory device. Although the present invention has been described with reference to preferred embodiments, workers skilled in the art will recognize that changes may be made in form and detail without departing from the scope of the invention as defined by the claims.

## Claims

1. A system for monitoring wear in a flash memory device (12) that is written by receiving program and erase commands from a microprocessor (16) on a memory bus (20), the system comprising:
a non-volatile memory (18) separate from the flash memory device that stores a number of completed erase cycles for each sector of the flash memory device; and
a memory monitor circuit (14) that monitors the memory bus for a completed erase cycle for an erased sector and updates the number of completed erase cycles in the non-volatile memory for the erased sector.

2. The system of claim 1, wherein the memory monitor circuit comprises:
a sequence detector (28) that monitors the memory bus for erase command sequences and determines the erased sector of the flash memory following a completed erase cycle; and
a sector erase counter (30) connected to the sequence detector that updates the number of completed erase cycles in the non-volatile memory for the erased sector.

3. The system of claim 2, wherein the sequence detector determines the erased sector by detecting an acknowledgement from the flash memory device.

4. The system of claim 1, wherein the memory monitor circuit is a field-programmable gate array (FPGA).

5. The system of claim 1, wherein the flash memory device comprises one or more NOR flash memory devices.

6. The system of claim 1, wherein the non-volatile memory is a non-volatile static random-access memory (SRAM) device.

7. A method for monitoring wear in a flash memory device, the method comprising:
monitoring a memory bus (20) for erase command sequences issued by a microprocessor (16) and provided to the flash memory device (12);
determining a memory sector of the flash memory for which the erase cycle is directed;
confirming that the erase cycle has been completed for the memory sector; and
updating an erase count for the memory sector of the flash memory device in a non-volatile memory that is separate from the flash memory device.

8. The method of claim 7, wherein monitoring the memory bus comprises monitoring the memory bus using a flash memory monitor circuit

9. The method of claim 8, wherein the flash memory monitor circuit comprises a sequence detector that monitors the memory bus, and a sector erase counter that updates erase counts in the non-volatile memory.

10. The method of claim 9, wherein updating the erase count comprises:
providing an address of the memory sector from the sequence detector to the sector erase counter; and
updating the erase count for the memory sector using the sector erase counter.

11. A wear monitor circuit for monitoring wear of a flash memory device that is written by receiving program and erase commands from a microprocessor on a flash memory bus, the wear monitor circuit comprising:
a first bus interface connected to the flash memory bus (20);
an erase sequence detection module (28) that connects to the first bus interface to detect erase cycles on the flash memory bus;
a second bus interface connected to a non-volatile memory (18); and
a sector erase update counter (30) that updates an erase cycle count for an erased sector in the non-volatile memory when the erase sequence detection module detects a completed erase cycle for the erased sector.

12. The circuit of claim 11, wherein the flash memory device comprises one or more NOR flash memory devices.

13. The circuit of claim 11, wherein the first and second bus interfaces, the erase sequence detection module and the sector erase update counter are implemented on a field-programmable gate array (FPGA).

14. The circuit of claim 11, wherein the non-volatile memory is a non-volatile static random-access memory (SRAM) device.

15. The circuit of claim 11, further comprising a local bus between the first bus interface and the second bus interface, wherein the microprocessor accesses the non-volatile memory through the local bus.
